# EUROPEAN PATENT SPECIFICATION

(11) **EP 0 356 055 B1**
(45) Date of publication and mention of the grant of the patent: **20.03.1996**
(21) Application number: 89307988.9
(22) Date of filing: 04.08.1989
(51) Int. Cl.: H03D 3/00

(54) **Interference suppression for transmitted signals and demodulation of vestigial sideband signals**
Übersprechstörung für übertragene Signale und Demodulation von Restseitenbandsignalen
Suppression d'interférence pour signaux transmis et démodulation de signaux de bande résiduelle

(30) Priority: 05.08.1988 GB 8818693
(43) Date of publication of application: 28.02.1990
(73) Proprietor: National Transcommunications Limited, Winchester, Hampshire SO21 2QA (GB)
(72) Inventor: Beech, Brian Herbert, Bishopstoke, Hampshire SO5 6NR (GB)
(74) Representative: Crawford, Andrew Birkby

(56) References cited:
- DE-B- 1 217 464
- IEEE TRANSACTIONS ON COMMUNICATIONS, vol. COM-32, no. 11, November 1984, pages 1224-1227, IEEE, New York, US; M.L. DUKIC et al.: "A new robust FM demodulator reducing adjacent radio-channel interference noise"
- IEEE TRANSACTIONS ON COMMUNICATIONS, vol. COM-29, no. 7, July 1981, pages 1001-1011, IEEE, New York, US; Z.D. STOJANOVIC et al.: "A new demodulation method improving FM system interference immunity"

## Description

The present invention relates to interference suppression for transmitted signals, in particular to suppression of interference caused by signals being transmitted in channels adjacent to the channel in which the signal concerned is being transmitted (adjacent channel interference).

The present invention further relates to the demodulation of vestigial sideband signals, for example vestigial sideband f.m. signals.

In most industrialised areas there is limited available space in the frequency spectrum in relation to the demand for bandwidth to accommodate radio and television channels, cellular telephony etc. Accordingly it is desirable to be able to pack transmission channels into the frequency spectrum as densely as possible. However, adjacent channel interference (A.C.I.) arises if neighbouring channels are too close together in the frequency spectrum.

Obviously it would be desirable to be able to eliminate the A.C.I. which occurs when signals are transmitted due to the crowded frequency spectrum. When it is desired to increase the bandwidth of a channel, or to decrease the spacing between channels, then elimination of A.C.I. may be a specific requirement in order for the received signals to be of an acceptable quality.

Taking multiplexed analogue component (MAC) television signals as an example, it has been shown by subjective tests that the proposals for D-MAC dbs transmission meet the requirements of WARC/77 for adjacent channel interference (WARC/77 in a series of standards which were agreed at an international satellite broadcasting planning conference. WARC/77 requires that a carrier of an adjacent channel should be 15dB down on the carrier of the wanted channel. This gives just perceptible interference). However, for the higher definition MAC signals, wherein more information than normal is transmitted in the signal to obtain, for example, a wider aspect ratio picture, W MAC and HD MAC, the wider receiver bandwidth results in a worse and possibly unacceptable interference performance. Also, if D-MAC is operated on a narrower channel spacing, there is a potential interference problem.

Two modes of interference which contribute to adjacent channel interference are as follows:-
a) Interference from noise-like signals of the unwanted signal into the wanted signal. This occurs in signals such as MAC, where digital data from the digital burst of an adjacent channel MAC signal can intrude into the vision part of the desired MAC signal, and in A.C.I. between adjacent sound channels.
b) Static tone interference, for f.m. signals in general.

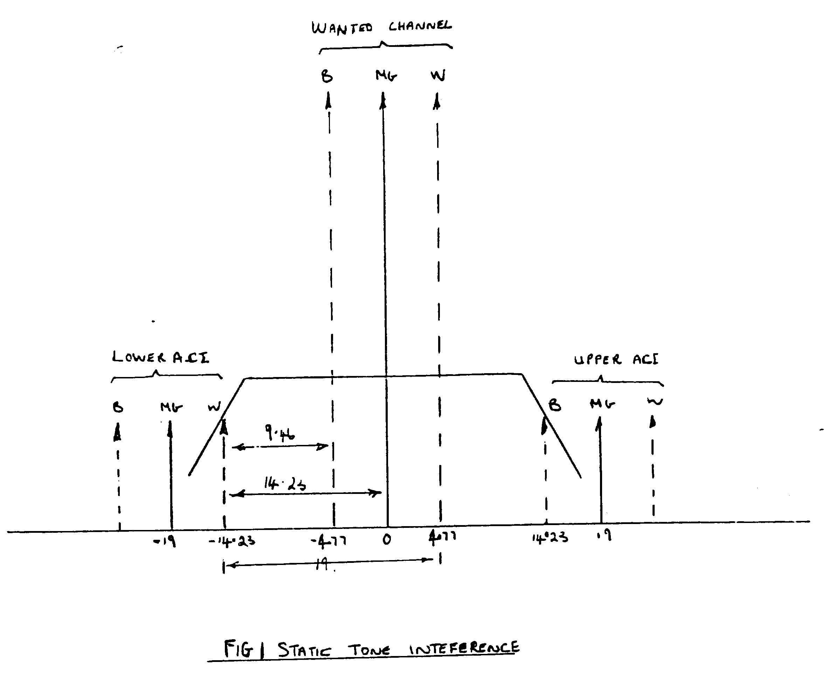

Static tone interference is generally considered to be the worst problem for television channels. Figure 1 illustrates how this mode of interference arises for f.m. signals. The carrier of the adjacent channel can fall within the receiver I.F. filter passband resulting in a baseband tone in the wanted channel. For 19MHz channel spacing the frequency of this tone will be between 9.46MHz and 19MHz.

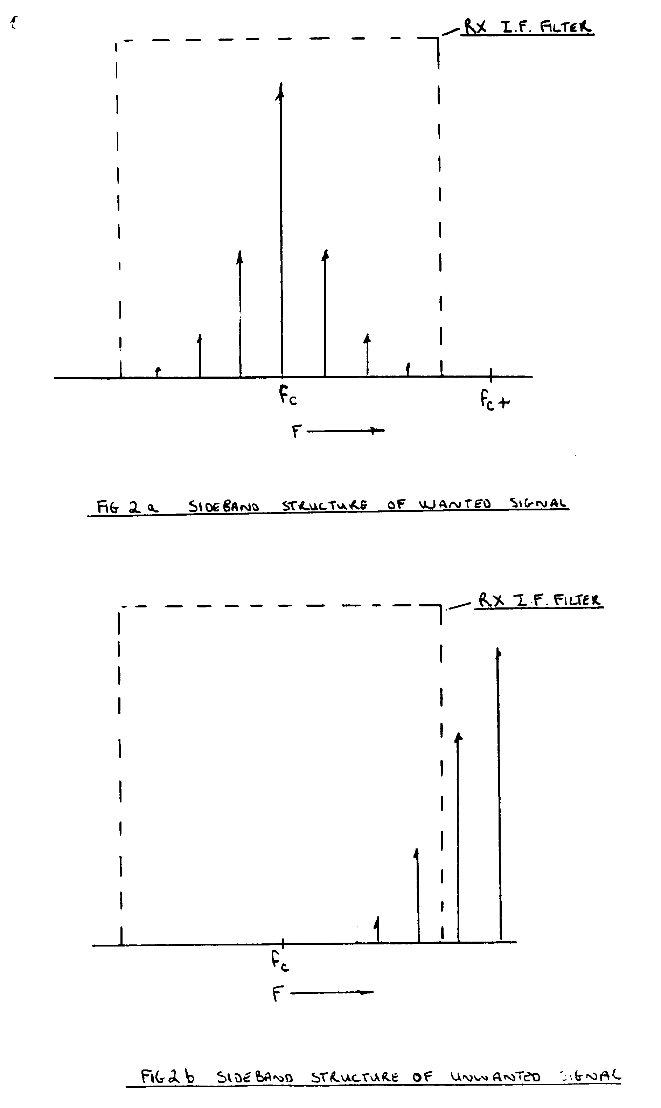

Figure 2a shows the sideband structure of the wanted signal. It contains a multiplicity of sidebands. Most of the energy falls within the bandwidth of the receiver I.F. filter. The sidebands occur in pairs and their phase relative to carrier is 90°.

Figure 2b shows the sideband structure of an unwanted signal. For static tone interference only one component will fall within the receiver (RX) I.F. filter bandwidth. In the general case, there will be a number of components within the RX bandwidth. These will generally fall on the same side of the receiver centre frequency as does the carrier of the interfering signal. Only a small amount of energy from the interfering signal will fall on the opposite side.

German patent 1217464 suggests that noise affecting the output of an f.m. demodulator may be compensated by f.m. and a.m. demodulating the input f.m. signal and forming a weighted combination of the demodulated signals.

From figure 2 it can be seen that sidebands resulting from the wanted signal are recognisable in that they come in pairs, symmetrically spaced about carrier and at a phase of 90° to it. Sidebands resulting from the interfering signal appear singly and in some arbitrary phase to the wanted carrier.

The present invention utilises this fundamental difference to distinguish interference from the wanted signal so that the interfering sidebands may be separated from the desired signal and suppressed.

The article "A New Robust FM Demodulator Reducing Adjacent Radio-Channel Interference Noise", by Dukic et al, IEEE Transactions on Communications COM-32 (1984) Nov., No.11, describes an f.m. demodulator which also makes use of the above-mentioned property of an interferer.

In the described apparatus a correction signal, to be applied to an f.m. demodulated signal so as to reduce adjacent channel interference, is produced by processing a signal corresponding to the square of the envelope of the input signal. The correction signal is proportional to the frequency of the "square" signal. Although this correction signal could, in theory, completely cancel the fundamental component of the adjacent channel interferer it has little effect on the harmonics of the interferer which may themselves fall within the baseband of the wanted signal.

As an alternative to the above-mentioned approach, a correction signal may be produced by processing a signal corresponding to the amplitude variation of the input signal, rather than the square of the envelope. The effect of this correction signal is to significantly reduce the interfering harmonics as well as the fundamental, leading to a greater overall reduction in the power of the interfering signal.

The present invention utilises a triangulator, i.e. a device which processes an input signal with a type of filtering function to produce an output the magnitude of which is a function of the frequency of the input signal. A triangulator is effectively equivalent to a differentiator but its output does not have the 90° phase shift possessed by the output of a differentiator.

A disadvantage with the alternative technique mentioned above is that the a.m. demodulation step results in an addition of noise to the signal. This noise can he reduced if the cancellation process is applied over only a part of the signal. Preferably, a filter step is included in the method to allow only a desired part of the signal to be passed for the cancellation process.

For a MAC television signal the adjacent channel interference occurs mainly at the top of the video-baseband (i.e. at the higher frequencies), so, for such a video signal it is preferred to high pass filter the a.m. demodulated signal prior to cancellation with the f.m. demodulated signal. This has the advantage of reducing the amount of noise added to the interference cancelled signal by the a.m. demodulation step.

In general, for any f.m. signal, adjacent channel interference will tend to affect the high frequencies of the demodulated signal rather than the low frequencies, and therefore a high pass filter step after the a.m. demodulation step will have the advantage of reducing noise.

The process can, in principle, completely eliminate interference from an adjacent channel to one side of the desired signal channel. However, if interference is also occurring on the other side of the desired signal channel, (i.e. on the other side of the wanted carrier) problems arise, because there will be no phase reversal of the output from the a.m. demodulation step whereas phase reversal occurs at the f.m. demodulator output. Therefore it will be necessary to change the polarity of the a.m. demodulated signal in order to get correct cancellation of interference.

If adjacent channel interference occurs on both sides of the carrier at the same time it is difficult to eliminate.

For T.V. signals, however, at any time the wanted carrier will be of a frequency which represents a grey level of picture. A variable gain stage controlled by the frequency of the f.m. demodulated signal can be used to produce a correction signal which will cancel interference on either side of the wanted carrier, the side being cancelled depending on the level of the f.m. demodulated signal. For example, when the wanted signal is approaching white, interference from the upper channel will be suppressed. When the wanted signal is approaching black, interference from the lower channel will be suppressed. And when the wanted signal is at mid-grey level there is no suppression of interference, however the level of interference from either side in this case may not be significant dependent upon factors such as channel spacing.

The present invention can be used with vestigial sideband signals, such as vestigial sideband f.m. Vestigial sideband a.m. is currently used in the U.K. for PAL transmission.

Vestigial sideband f.m. is envisaged for transmission of such signals as D-MAC over cable. A process in accordance with the present invention can advantageously be used to reconstruct the missing sideband, by adding the differentiated a.m. demodulated signal to the f.m. demodulated signal.

The present invention provides a method for receiving a vestigial sideband signal comprising the steps of:
receiving the vestigial sideband signal as an input;
f.m. demodulating the input signal;
a.m. demodulating the input signal;
processing the a.m. demodulated signal to produce a further signal the magnitude of which is proportional to the frequency of the a.m. demodulated signal; and
adding the further signal to the f.m. demodulated signal, the further signal and the f.m. demodulated signal being controlled to be in phase before being added, whereby to substantially compensate for the vestigial sideband, and outputting the resultant signal.

The present invention further provides apparatus for receiving a vestigial sideband signal, comprising:
means for receiving the vestigial sideband signal as an input;
f.m. demodulating means for f.m. demodulating the input signal;
a.m. demodulating means for a.m. demodulating the input signal;
means for processing the a.m. demodulated signal to produce a further signal the magnitude of which is proportional to the frequency of the a.m. demodulated signal; and
combining means for adding the further signal to the f.m. demodulated signal, the further signal and the f.m. demodulated signal being controlled to be in phase before being combined, wehereby to substantially compensate for the vestigial sideband, and outputting the resultant signal.

A similar technique can also be used with advantage to cater for uplink interference in, for example, satellite broadcasting systems.

Downlink interference occurs to the transmitted signal between the satellite and ground, and can be reduced in accordance with the interference suppression method of the present invention by cancelling the f.m. demodulated signal by the triangulated a.m. demodulated signal. However, the uplink interference (caused between ground and satellite) cannot be reduced by this technique, due to the non-linearity of the satellite transponder.

However, if the usual wideband signal is filtered in the receiver prior to demodulation, so as remove one sideband containing interference and thus to produce a signal resembling a vestigial sideband f.m. signal, then the missing sideband may be reconstructed by adding the triangulated a.m. demodulated signal to the demodulated f.m. signal. This is one way of catering for uplink interference; it is also useful when a strong interfering signal affects one sideband only of the wanted signal.

The present invention still further provides a method for receiving a wideband signal comprising the steps of:
receiving the transmitted signal as an input;
filtering the input signal to substantially; remove one sideband and the associated noise;
f.m. demodulating the filtered signal;
a.m. demodulating the filtered signal;
processing the a.m. demodulated signal to produce a further signal the magnitude of which is proportional to the frequency of the a.m. demodulated signal; and
adding the further signal to the f.m. demodulated signal, the further signal and the f.m. demodulated signal being controlled to be in phase before being added, whereby to substantially compensate for the removed sideband, and outputting the resultant signal.

The present invention yet further provides apparatus for receiving a wideband signal, comprising:
means for receiving the wideband signal as an input;
means for filtering the input signal to substantially remove one sideband and the associated noise;
f.m. demodulating means for f.m. demodulating the input signal;
a.m. demodulating means for a.m. demodulating the input signal;
means for processing the a.m. demodulated signal to produce a further signal the magnitude of which is proportional to the frequency of the a.m. demodulated signal; and
combining means for adding the further signal to the f.m. demodulated signal, the further signal and the f.m. demodulated signal being controlled to be in phase before being combined, whereby to substantially compensate for the removed sideband, and outputting the resultant signal.

Features and advantages of the present invention will become apparent from the following description of an embodiment thereof, by way of example only, with reference to the accompanying figures, in which:-
Figure 1 is a diagram to illustrate how static tone interference arises from adjacent channels;
Figure 2a is a diagram showing the sideband structure of an f.m. signal;
Figure 2b is a diagram showing the sideband structure of an interfering channel;
Figure 3a is a vector diagram illustrating a wanted carrier plus an interfering sideband;

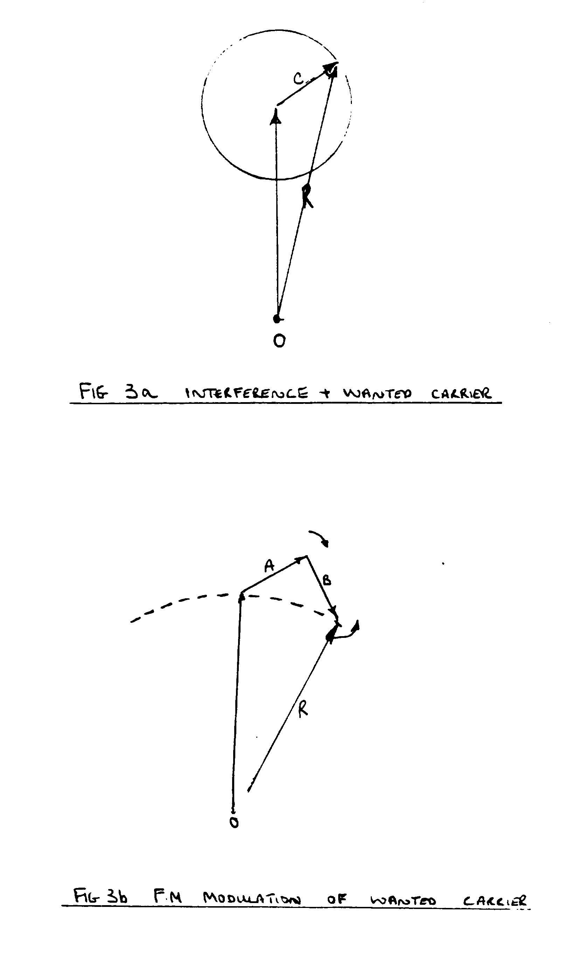

Figure 3a is a vector diagram of a wanted carrier with f.m modulation

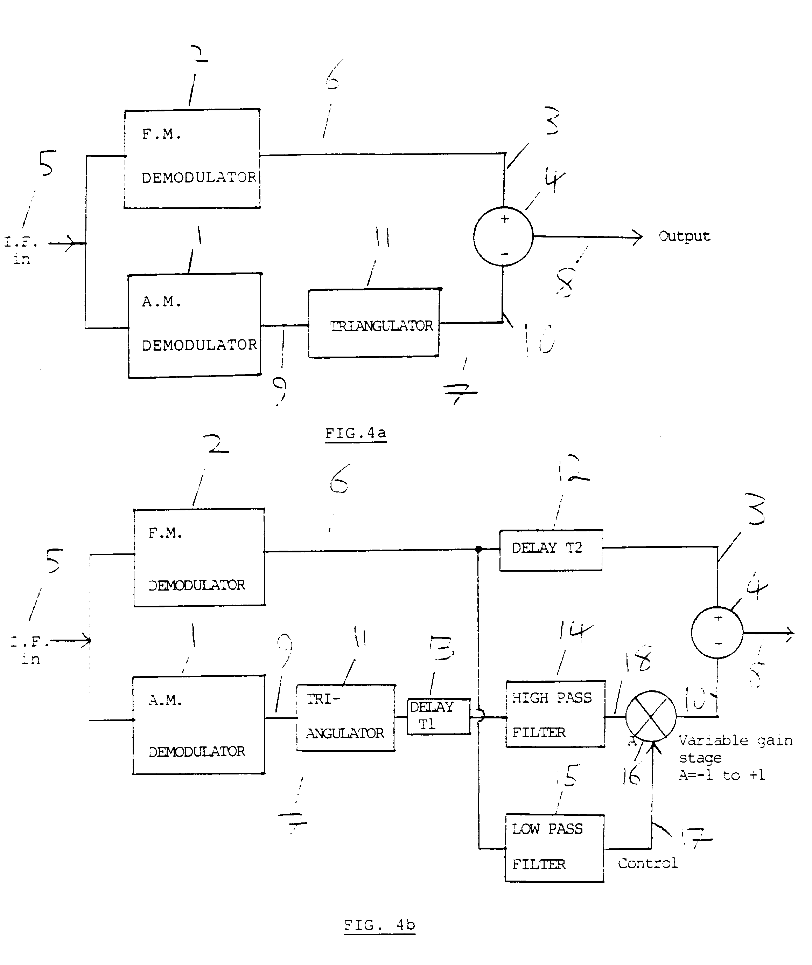

Figure 4a illustrates an apparatus which is useful for the understanding of the invention.
Figure 4b illustrates further apparatus which is useful for the understanding of the invention.

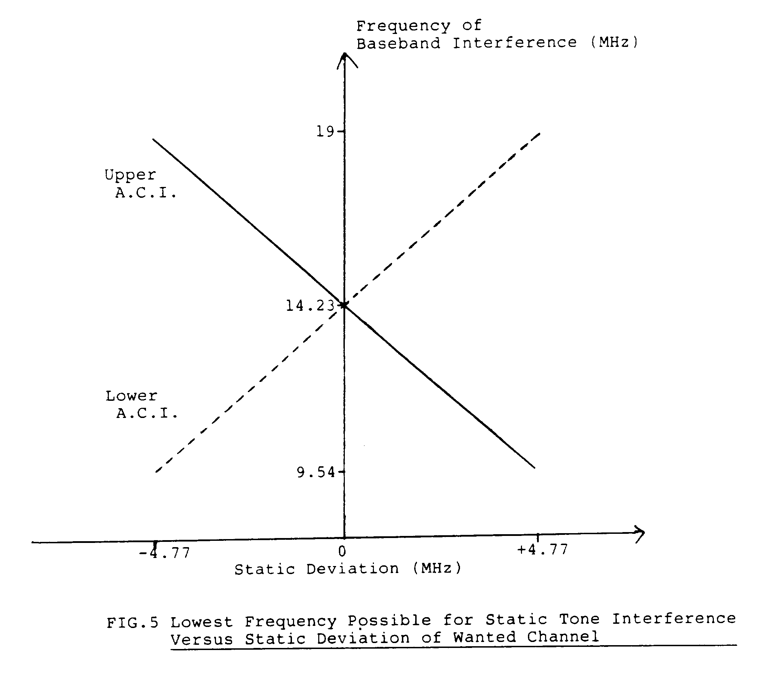

Figure 5 shows a graph of frequency of baseband interference against static deviation for a MAC transmitted signal;

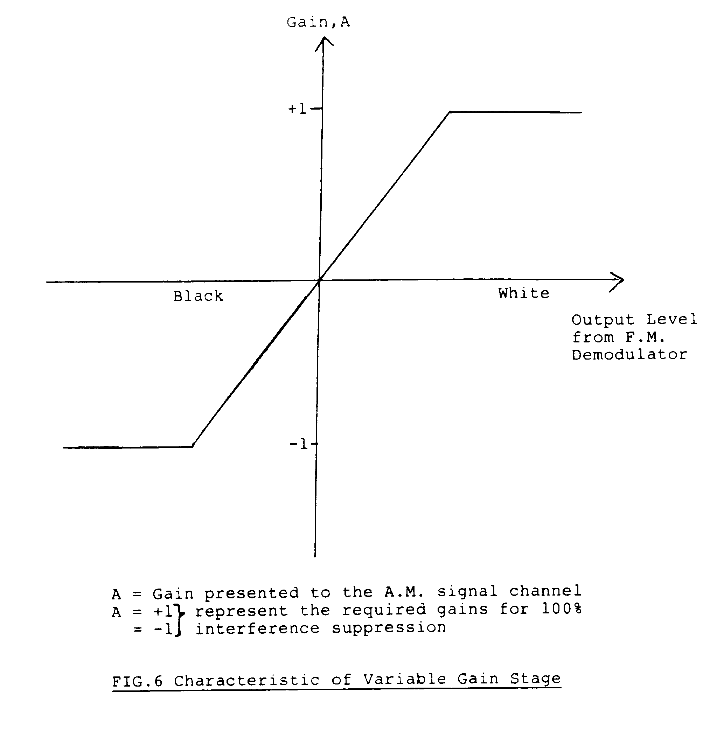

Figure 6 shows a characteristic of the variable gain stage of Figure 4b, and
Figure 6 shows a graphical representation of a vestigial sideband frequency modulated signal.

The following description relates to transmission and reception of an f.m signal, such as e.g. a MAC television signal (ie, D MAC, HD MAC, W MAC etc).

Figure 3b shows a vector representation of the wanted carrier with f.m modulation. The modulation sidebands A, B are represented by two counter rotating vectors. The resultant vector R changes phase but not amplitude.

Figure 3a represents the wanted carrier plus an interfering sideband. In this case, the resultant vector R varies in both amplitude and phase. If this signal is subjected to both an f.m demodulation process and an a.m demodulation process, then a sine wave will be produced at both demodulator outputs.

The signal from the a.m demodulator will be in phase with that from the f.m demodulator. Furthermore, if difference frequency between the wanted carrier and unwanted sideband is F, then the amplitude of the output from the a.m demodulator will be independent of F whereas that from the f.m demodulator will be linearly proportional to F.

Fig. 4a shows a method by which interference cancellation can be achieved for all values of F. The output from the a.m demodulator 1 is subjected to a triangulation process and then subtracted from the output of the f.m demodulator 2. For a genuine f.m modulating signal the f.m demodulator output 3 passes through the summing node 4 uncorrupted, since there is no output from a.m demodulator 1. For an interfering signal, the gains of the f.m and a.m channel 6,7 can be set to achieve total rejection of that signal as seen at the final output 8.

The improvement in interference performance is achieved at the expense of a signal to noise degradation. It can be shown that the contribution of noise from the a.m demodulator 1 is exactly the same as that from the f.m demodulator 2, resulting in a S/N ratio penalty of 3dB.

If the cancellation process is applied only over a part of the baseband, instead of the whole of it, then this noise penalty is reduced.

Generally, the baseband interference occurs mainly at the top of the baseband, so the system is still effective if a high pass filter is included as in Figure 4b. (This is the block diagram of a preferred system). Typically, by this means, the noise penalty can be reduced to less than 1dB.

If the interfering signal moves from one side of the wanted carrier to the other, then there will be a phase reversal of the output 3 from the f.m demodulator 2 but no phase reversal of the output 9 from the a.m demodulator 1. This means that the polarity of the correction signal 10 must be different depending on which side of the wanted carrier the interference falls.

In principle, therefore, the technique can totally eliminate single sided interference but there may be a problem if interference falls on both sides of the carrier at the same time. In Figure 4b a variable gain stage 16 is included as a means of controlling the phase 0°/180° and amplitude of the correction signal.

For dbs of television signals operated on a 19MHz channel spacing, although interference will in general be present on both sides of the wanted carrier at the same time, the system can be arranged so that at any one time there will be a contribution only from one side. Figure 5 illustrates this. It can be seen that for a static deviation of the wanted channel of 0 the lowest possible static tone interfering frequency is 14.23MHz.

If the video baseband is low pass filtered to a frequency lower than this it follows from Figure 5 that, for positive static deviations, static tone interference can only come from the upper adjacent channel. For negative static deviations it can only come from the lower adjacent channel. It is possible, therefore, to determine the phase required of the correction signal by monitoring the polarity of the output of the f.m demodulator. (This must be either dc coupled or clamped).

Figure 4b, shows another arrangement the output from the f.m demodulator 2 is low pass filtered 15 and then used as the control signal of a variable gain stage 16. The gain versus control voltage characteristic of the variable gain stage is typically as shown in Figure 6.

At mid-grey no a.m component is passed to the output summing node 4.

At levels greater than 50% of peak white and less than 50 % of peak black the correct phase of signal is provided at the amplitude required for 100% interference suppression.

For other levels a smooth gain transition is provided as in Figure 6.

Delay element T₁ 13, is necessary to guarantee that both the control signal 17 and input signal 18 to the variable gain stage, are timed correctly relative to each other.

Delay element T₂ 12 is necessary to guarantee that the f.m and a.m components are timed correctly relative to each other at the output summing node 14.

So far, consideration has been given only to static tone (sine wave) interference. The system will also operate effectively even when the interference is noise like. Typically, the interference from the digital data of a MAC signal in the unwanted channel into the wanted channel is in this category.

At mid-grey, no interference suppression is provided by this arrangement. This does not matter since for dbs transmissions with this channel spacing at mid-grey the level of interference from both upper and lower channels is adequately low.

For levels approaching peak white and black the interference from upper and lower channels respectively is totally suppressed.

The arrangements shown in Fig. 4a & 4b rely on the extraction of both the f.m and a.m components of the received signal 5. It is important, therefore, that the channel should be linear between the point at which the interference becomes added to the wanted signal and the receiver.

When considering dbs of television signals downlink interference meets this requirement. but it must be assumed that the system will not provide any improvement to uplink interference, due to the non linearity of the satellite transponder.

Nevertheless, the uplink contribution will be normally substantially less than the downlink contribution so the system can provide an overall improvement.

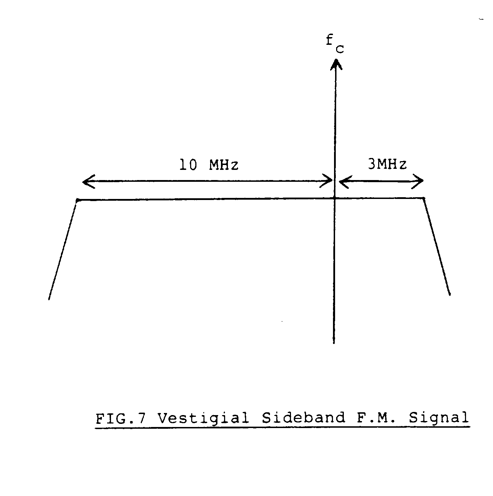

Vestigial sideband am transmission is currently used for PAL. Vestigial sideband fm has been proposed for cable transmission of DMAC. Figure 7 illustrates the form of filtering proposed. It allows frequency components to about 10 Mhz below vision centre frequency, but only to about 3 MHz above.

The consequence of VSB transmission is that if a conventional f.m demodulator is used, then the baseband frequency response will be substantially non flat. Equalisation either at the transmitter or the receiver may improve this. In a TV system the non-flatness will be dependent on picture grey level, so accurate equalisation is difficult.

The interference suppression technique of the present invention can be used as a means of reducing distortion in the demodulation of VSB f.m. Consider the circuit of figure 4a modified so that the output for the triangulator is added to that for the f.m demodulator rather than being subtracted from it.

Now, instead of single sideband components being suppressed, they will be increased by 6dB.

At low baseband frequencies, both sidebands will be present (Fig 7). The a.m demod output 3 will be zero and the f.m demod output 9 will be the correct amplitude.

At high baseband frequencies, the output from the d.m demod 3 will reduce by 6dB, but will be reinforced by the a.m demod output 3 to produce the correct overall result.

There is no confusion here over the polarity of "correction" signal required since the sense of the assymetry of the IF filtering will be known.

Application of this technique also allows the transmission of HD-MAC/WMAC by VSB FM which may otherwise not be possible. Since a VSB signal occupies less bandwidth than a full signal this technique should enable closer channel spacing in the frequency spectrum.

Further, this method could be used to remove uplink interference, by filtering the wideband signal so that it resembles the vestigial sideband signal (thereby effectively removing the uplink interference on that side). then reconstructing the missing sideband by using the above technique.

The present invention has been described generally in terms of frequency modulated signals and particularly in terms of MAC television signals. It can be utilised for any f.m transmission, or even a.m transmission. It is not limited to satellite broadcasting, it can be used with any method of broadcasting, for example cable, MVDS, etc.

The benefits of this system include:-
1. Total elimination of the affects of single sided downlink interference.
   This is achievable irrespective of the nature of the interference.
2. Substantial improvement to double sided static tone downlink interference.
3. Some improvement to double sided interference when this arises from the digital part of the unwanted signal.

## Claims

1. A method for receiving a vestigial sideband signal comprising the steps of:
receiving the vestigial sideband signal as an input;
f.m. demodulating the input signal;
a.m. demodulating the input signal;
processing the a.m. demodulated signal to produce a further signal the magnitude of which is proportional to the frequency of the a.m. demodulated signal; and
adding the further signal to the f.m. demodulated signal, the further signal and the f.m. demodulated signal being controlled to be in phase before being added, whereby to substantially compensate for the vestigial sideband, and outputting the resultant signal.

2. A method for receiving a wideband signal comprising the steps of:
receiving the transmitted signal as an input;
filtering the input signal to substantially remove one sideband and the associated noise;
f.m. demodulating the filtered signal;
a.m. demodulating the filtered signal; processing the a.m. demodulated signal to produce a further signal the magnitude of which is proportional to the frequency of the a.m. demodulated signal; and
adding the further signal to the f.m. demodulated signal, the further signal and the f.m. demodulated signal being controlled to be in phase before being added, whereby to substantially compensate for the removed sideband, and outputting the resultant signal.

3. A method according to Claims 1 or 2, and comprising the step of high pass filtering the further signal before combination thereof with the f.m. demodulated signal.

4. Apparatus for receiving a vestigial sideband signal, comprising:
means for receiving the vestigial sideband signal as an input(5);
f.m. demodulating means (2) for for f.m. demodulating the input signal;
a.m. demodulating means (1) for a.m. demodulating the input signal;
means (11) for processing the a.m. demodulated signal to produce a further signal the magnitude of which is proportional to the frequency of the a.m. demodulated signal; and
combining means (4) for adding the further signal to the f.m. demodulated signal, the further signal and the f.m. demodulated signal being controlled to be in phase before being combined, whereby to substantially compensate for the vestigial sideband, and outputting resultant signal.

5. Apparatus for receiving a wideband signal, comprising:
means for receiving the wideband signal as input (5);
means for filtering the input signal to substantially remove one sideband and the associated noise;
f.m. demodulating means (2) for f.m. demodulating the input signal;
a.m. demodulating means (1) for a.m. demodulating the input signal;
means (11) for processing the a.m. demodulated signal (9) to produce a further signal the magnitude of which is proportional to the frequency of the a.m. demodulated signal; and
combining means for adding the further signal (1) to the f.m. demodulated signal (3), the further signal and the f.m. demodulated signal being controlled to be in phase before being combined, whereby to substantially compensate for the removed sideband, and outputting the resultant signal.

6. Apparatus according to Claim 4 or 5 and further comprising a high pass filter arranged to operate on the output of the a.m. demodulated signal processing means.

## Patentansprüche

1. Verfahren zum Empfangen eines Restseitenbandsignals, das die folgenden Schritte umfaßt:
Empfangen des Restseitenbandsignals als einen Eingang;
FM-Demodulieren des Eingangssignals;
AM-Demodulieren des Eingangssignals;
Verarbeiten des AM-demodulierten Signals, um ein weiteres Signal zu erzeugen, dessen Amplitude proportional zur Frequenz des AM-demodulierten Signals ist; und
Addieren des weiteren Signals zu dem FM-demodulierten Signal, wobei das weitere Signal und das FM-demodulierte Signal so gesteuert werden, daß sie phasengleich sind, bevor sie addiert werden, so daß im wesentlichen Kompensation für das Restseitenband stattfindet, und Ausgeben des entstandenen Signals.

2. Verfahren zum Empfangen eines Breitbandsignals, das die folgenden Schritte umfaßt:
Empfangen des gesendeten Signals als einen Eingang;
Filtern des Eingangssignals, um im wesentlichen ein Seitenband und das dazugehörige Rauschen zu beseitigen;
FM-Demodulieren des gefilterten Signals;
AM-Demodulieren des gefilterten Signals;
Verarbeiten des AM-demodulierten Signals, um ein weiteres Signal zu erzeugen, dessen Amplitude proportional zur Frequenz des AM-demodulierten Signals ist; und
Addieren des weiteren Signals zu dem FM-demodulierten Signal, wobei das weitere Signal und das FM-demodulierte Signal so gesteuert werden, daß sie phasengleich sind, bevor sie addiert werden, so daß im wesentlichen Kompensation für das beseitigte Seitenband stattfindet, und Ausgeben des entstandenen Signals.

3. Verfahren nach Anspruch 1 oder 2, das den Schritt des Hochpaßfilterns des weiteren Signals vor Kombinierung desselben mit dem FM-demodulierten Signal umfaßt.

4. Vorrichtung zum Empfangen eines Restseitenbandsignals, die umfaßt:
eine Einrichtung, die das Restseitenbandsignal als einen Eingang (5) empfängt;
eine FM-Demodulationseinrichtung (2), die das Eingangssignal FM-demoduliert;
eine AM-Demodulationseinrichtung (1), die das Eingangssignal AM-demoduliert;
eine Einrichtung (11), die das AM-demodulierte Signal verarbeitet, um ein weiteres Signal zu erzeugen, dessen Amplitude proportional zur Frequenz des AM-demodulierten Signals ist; und
eine Kombinierungseinrichtung (4), die das weitere Signal zu dem FM-demodulierten Signal addiert, wobei das weitere Signal und das FM-demodulierte Signal so gesteuert werden, daß sie phasengleich sind, bevor sie kombiniert werden, so daß im wesentlichen Kompensation für das Restseitenband stattfindet, und das entstandene Signal ausgibt.

5. Vorrichtung zum Empfangen eines Breitbandsignals, die umfaßt:
eine Einrichtung, die das Breitbandsignal als Eingang (5) empfängt;
eine Einrichtung, die das Eingangssignal filtert, um im wesentlichen ein Seitenband und das dazugehörige Rauschen zu beseitigen;
eine FM-Demodulationseinrichtung (2), die das Eingangssignal FM-demoduliert;
eine AM-Demodulationseinrichtung (1), die das Eingangssignal AM-demoduliert;
eine Einrichtung (11), die das AM-demodulierte Signal (9) verarbeitet, um ein weiteres Signal zu erzeugen, dessen Amplitude proportional zur Frequenz des AM-demodulierten Signals ist; und
eine Kombinierungseinrichtung, die das weitere Signal (1) zu dem FM-demodulierten Signal (3) addiert, wobei das weitere Signal und das FM-demodulierte Signal so gesteuert werden, daß sie phasengleich sind, bevor sie kombiniert werden, so daß im wesentlichen Kompensation für das beseitigte Seitenband stattfindet, und das entstandene Signal ausgibt.

6. Vorrichtung nach Anspruch 4 oder 5, die des weiteren ein Hochpaßfilter umfaßt, das auf den Ausgang der Verarbeitungseinrichtung für das AM-demodulierte Signal einwirkt.

## Revendications

1. Procédé de réception d'un signal à bande latérale atténuée comprenant les étapes :
de réception, comme entrée, du signal à bande latérale atténuée ;
de démodulation FM du signal d'entrée ;
de démodulation AM du signal d'entrée ;
de traitement du signal démodulé AM pour produire un signal supplémentaire dont l'amplitude est proportionnelle à la fréquence du signal démodulé AM ; et
d'addition du signal supplémentaire au signal démodulé FM, le signal supplémentaire et le signal démodulé FM étant commandés pour être en phase avant d'être additionnés, pour compenser ainsi sensiblement la bande latérale atténuée, et de sortie du signal résultant.

2. Procédé de réception d'un signal à large bande comprenant les étapes :
de réception, comme entrée, du signal émis ;
de filtrage du signal d'entrée pour éliminer sensiblement une bande latérale et le bruit associé ;
de démodulation FM du signal filtré ;
de démodulation AM du signal filtré ;
de traitement du signal démodulé AM pour produire un signal supplémentaire dont l'amplitude est proportionnelle à la fréquence du signal démodulé AM ; et
d'addition du signal supplémentaire au signal démodulé FM, le signal supplémentaire et le signal démodulé FM étant commandés pour être en phase avant d'être additionnés, pour compenser ainsi sensiblement la bande latérale éliminée, et de sortie du signal résultant.

3. Procédé selon la revendication 1 ou 2, et comprenant l'étape de filtrage passe-haut du signal supplémentaire avant sa combinaison avec le signal démodulé FM.

4. Appareil de réception d'un signal à bande latérale atténuée, comprenant :
un moyen pour recevoir, comme entrée (5), le signal à bande latérale atténuée ;
un moyen de démodulation FM (2) pour démoduler FM le signal d'entrée ;
un moyen de démodulation AM (1) pour démoduler AM le signal d'entrée ;
un moyen de traitement (11) pour traiter le signal démodulé AM pour produire un signal supplémentaire dont l'amplitude est proportionnelle à la fréquence du signal démodulé AM ; et
un moyen de combinaison (4) pour additionner le signal supplémentaire au signal démodulé FM, le signal supplémentaire et le signal démodulé FM étant commandés pour être en phase avant d'être combinés, pour compenser ainsi sensiblement la bande latérale atténuée, et pour sortir le signal résultant.

5. Appareil de réception d'un signal à large bande, comprenant :
un moyen pour recevoir, comme entrée (5), le signal à large bande ;
un moyen pour filtrer le signal d'entrée pour éliminer sensiblement une bande latérale et le bruit associé ;
un moyen de démodulation FM (2) pour démoduler FM le signal d'entrée ;
un moyen de démodulation AM (1) pour démoduler AM le signal d'entrée ;
un moyen de traitement (11) pour traiter le signal démodulé AM (9) pour produire un signal supplémentaire dont l'amplitude est proportionnelle à la fréquence du signal démodulé AM ; et
un moyen de combinaison pour additionner le signal supplémentaire (1) au signal démodulé FM (3), le signal supplémentaire et le signal démodulé FM étant commandés pour être en phase avant d'être combinés, pour compenser ainsi sensiblement la bande latérale éliminée, et pour sortir le signal résultant.

6. Appareil selon la revendication 4 ou 5, et comprenant en outre un filtre passe-haut agencé pour opérer sur la sortie du moyen de traitement de signal démodulé AM.
